# EUROPEAN PATENT APPLICATION

(11) **EP 2 963 682 A1**
(43) Date of publication of application: **06.01.2016**
(21) Application number: 15169012.0
(22) Date of filing: 22.05.2015
(51) Int. Cl.: H01L 23/49, H01L 23/492

(54) **SEMICONDUCTOR DEVICE AND MANUFACTURING METHOD THEREOF**

(30) Priority: 30.06.2014 JP 2014133506
(71) Applicant: Hitachi, Ltd., Tokyo 100-8280 (JP)
(72) Inventor: Hozoji, Hiroshi, Tokyo 100-8220 (JP); Motowaki, Shigehisa, Tokyo 100-8220 (JP); Morita, Toshiaki, Tokyo 100-8280 (JP); Konno, Akitoyo, Tokyo 100-8220 (JP)
(74) Representative: Beetz & Partner mbB

(57) **Abstract**

The present invention provides a semiconductor device that has superior connection reliability of a main electrode and a control electrode provided on a principal surface of a semiconductor element and a connection wiring line such as bonding wire and improves connection workability of the control electrode and the connection wiring line. A control electrode (4) and a main electrode (3) provided on a principal surface of a semiconductor element (1) are electrically connected to connection wiring lines (7) and (9) having wire or ribbon shape through a conductive member. The conductive member is divided into a conductive member (6) for a control electrode connected to the control electrode (4) and a conductive member (5) for a main electrode connected to the main electrode (3), the conductive member (6) for the control electrode and the conductive member (5) for the main electrode are fixed by an insulating member (13), and an area of a surface of the conductive member (6) for the control electrode connected to the control electrode (4) is smaller than an area of a surface of the conductive member (6) for the control electrode connected to the connection wiring line (7).

## Description

### Technical Field

The present invention relates to a semiconductor module and more particularly, to a semiconductor device on which a semiconductor element for power conversion such as motor control is mounted and a manufacturing method thereof.

### Background Art

Motor drive used for a railroad, an electric vehicle, and a hybrid vehicle is generally controlled by a power converter (inverter) . A semiconductor module on which a switching element such as an insulated gate bipolar transistor (IGBT) or a metal oxide semiconductor field effect transistor (MOSFET) to control a large current and a semiconductor element called a free wheel diode (FWD) to release a reverse voltage at the time of switching are mounted is used in a portion called a main circuit of the inverter. In a field of vehicles, because a decrease in size and weight of a mounted apparatus is accelerated, a power density of each device or package tends to increase. For this reason, improvement of a wiring method and a connection life with a semiconductor device corresponding to the large current is strongly demanded.

PTL 1 discloses a method of bonding one metal plate to an electrode pad provided on a top surface of the semiconductor element by solder and connecting bonding wire. PTL 1 discloses technology for coupling a plurality of electrode pads for power start on the semiconductor element by a conductive member, securing a bonding region, and improving workability at the time of wire bonding.

### Citation List

### Patent Literature

PTL 1: JP 2003-229449 A

### Summary of Invention

### Technical Problem

In the IGBT element, an emitter electrode (main electrode) and a gate electrode (control electrode) are formed on a surface electrode and a collector element is formed on a back surface electrode. In the MOSFET element, a source electrode (main electrode) and a gate electrode (control electrode) are formed on a surface electrode and a drain electrode is formed on a back surface electrode. As disclosed in PTL 1, when the main electrode of the semiconductor element connecting the bonding wire is divided into a plurality of parts, the conductive member obtained by connecting the plurality of electrodes is provided, so that the region to connect the bonding wire is expanded, and the workability can be improved. However, in PTL 1, because the conductive member is not provided in the control electrode to control the semiconductor element, the workability at the time of the wire bonding to the control electrode is the same as the workability in the semiconductor device according to the related art. In a semiconductor device for power, it is effective to increase an area of the main electrode on the semiconductor element to flow a large amount of current. For this reason, if the control electrode is reduced, a wire bonding enabling area cannot be secured and the workability and connection reliability cannot be improved. Meanwhile, if the area of the control electrode is increased to improve the workability of the wire bonding to the control electrode, the area of the main electrode decreases and a large capacity of the element cannot be realized. In addition, the connection reliability is deteriorated due to an increase in calorific value of the main electrode to be a high heat generating portion.

Accordingly, the present invention has been made to solve the problems and an object of the present invention is to provide a semiconductor device that has superior connection reliability of a main electrode and a control electrode provided on a principal surface of a semiconductor element and a connection wiring line such as bonding wire and improves connection workability of the control electrode and the connection wiring line.

### Solution to Problem

In order to solve the above-described object, a semiconductor device according to the present invention is characterized in that a control electrode and a main electrode provided on a principal surface of a semiconductor element are electrically connected to connection wiring lines of wire or ribbon shapes through a conductive member, the conductive member is divided into a conductive member for a control electrode connected to the control electrode and a conductive member for a main electrode connected to the main electrode, the conductive member for the control electrode and the conductive member for the main electrode are fixed by an insulating member, and an area of a surface of the conductive member for the control electrode connected to the connection wiring line is larger than an area of a surface of the conductive member for the control electrode connected to the control electrode.

### Advantageous Effects of Invention

According to the present invention, a semiconductor device that has superior connection reliability of a main electrode and a control electrode provided on a principal surface of a semiconductor element and a connection wiring line such as bonding wire and improves connection workability of the control electrode and the connection wiring line can be provided.

### Brief Description of Drawings

Fig. 1 is a main portion perspective view of a semiconductor device according to a first embodiment.
Fig. 2 is a main portion perspective view illustrating a manufacturing process of the semiconductor device according to the first embodiment.
Fig. 3 is a main portion perspective view illustrating a manufacturing process of the semiconductor device according to the first embodiment.
Fig. 4 is a main portion perspective view illustrating a manufacturing process of the semiconductor device according to the first embodiment.
Fig. 5 is a main portion perspective view illustrating a manufacturing process of the semiconductor device according to the first embodiment.
Figs. 6 (a) to 6(e) are schematic views of manufacturing processes of a conductive member according to the first embodiment.
Fig. 7 is a main portion perspective view of a semiconductor device according to a second embodiment.
Fig. 8 is a main portion perspective view of a conductive member according to a third embodiment.
Fig. 9 is a main portion perspective view of a conductive member according to a fourth embodiment.
Figs. 10 (a) and 10 (b) are main portion perspective views of a conductive member according to a fifth embodiment.

### Description of Embodiments

Hereinafter, embodiments of the present invention will be described with reference to the drawings.

### [First Embodiment]

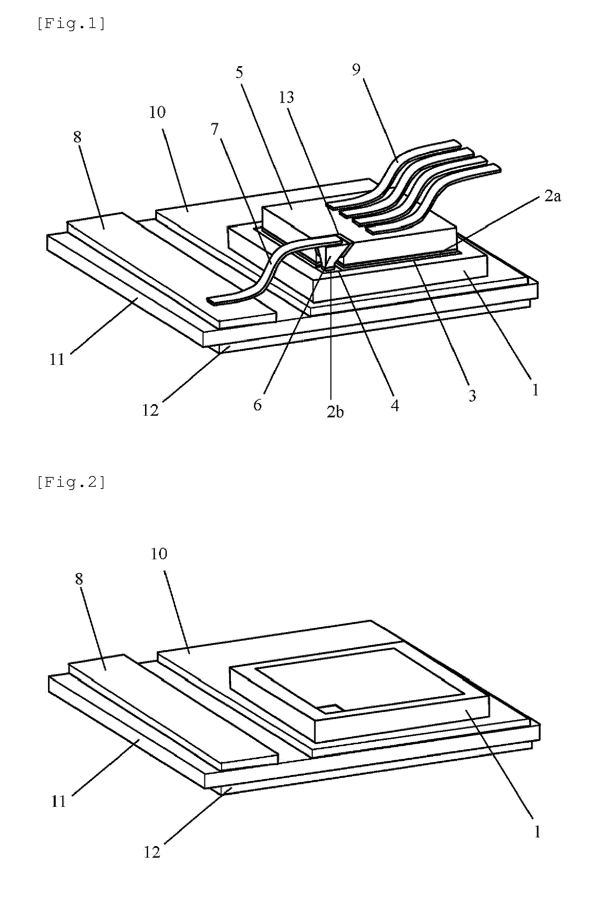

Fig. 1 is a main portion perspective view of a semiconductor device according to a first embodiment of the present invention. Fig. 1 does not illustrate a specific portion of the semiconductor device according to the present invention and does not illustrate a filling resin such as silicone gel, a case, a wiring line of the case and an insulating substrate, and a heat dissipation base. Fig. 2 is a main portion perspective view illustrating a manufacturing process of the semiconductor device according to this embodiment.

In the semiconductor device according to this embodiment, a semiconductor element 1 such as an IGBT element or a MOSFET element is mounted on an insulating wiring substrate provided with awiringpattern. In an insulating substrate 11 configuring the insulatingwiring substrate, aluminumnitride, silicon oxide, and alumina are used. Wiring patterns 8 and 10 made of metal conductors such as aluminum or copper are bonded to a surface of the insulating substrate 11 by brazing and a metal foil 12 made of a metal conductor such as aluminum or copper is bonded to a back surface by brazing. In addition, a conductive member 5 for a main electrode and a conductive member 6 for a control electrode are bonded to upper portions of a main electrode 3 and a control electrode 4 provided on a principal surface of the semiconductor element 1 through bonding members 2a and 2b. As the bonding members 2a and 2b, particulate paste of sintering silver or copper using soldering or low temperature sintering is used. In addition, particulate paste of silver oxide and copper oxide producing silver and copper by reduction can be used. The conductive member 5 for the main electrode and the conductive member 6 for the control electrode are fixed by an insulating member 13 and connection wiring lines 7 and 9 are connected to upper portions of the individual conductive members, respectively, and are connected to the wiring pattern 8 on the corresponding insulating substrate 11 or terminals (not illustrated in the drawings) provided on the case.

In this embodiment, an area of a surface of the conductive member 6 for the control electrode connected to the connection wiring line 7 is larger than an area of a surface of the conductive member 6 for the control electrode connected to the control electrode 4. The reason why the conductive member 6 is formed in the shape described above is as follows. The control electrode 4 is an electrode to apply a voltage to control switching of the semiconductor element 1. Because a gate current flows only during a short period of ON and OFF, an amount of current flowing instantaneously is about one several tenth or one several hundredth of an amount of current flowing between an emitter and a collector, and a voltage is low and a current is small, a large electrode area is not necessary. However, because a bonding area to secure connection strength of the wiring line and the electrode is necessary for connecting the connection wiring line 7 for the control electrode to the semiconductor element 1, it is necessary to increase the electrode area on the semiconductor element. Meanwhile, in a semiconductor element for power, it is effective to increase the area of the main electrode to flow a large amount of current to the semiconductor element 1. Therefore, it is preferable to connect the connection wiring line 7 to the control electrode 4, in a state in which the area of the control electrode 4 provided in the semiconductor element 1 is small and the area of the main electrode 3 is large. For this reason, in this embodiment, the conductive member 6 for the control electrode has the shape in which the area of the connection surface with the control electrode 4 is small and the area of the connection surface with the connection wiring line 7 is large. Even though the area of the control electrode 4 is decreased by the conductive member 6 for the control electrode, the area of the connection surface of the conductive member 6 for the control electrode to which the connection wiring line 7 is connected can be increased and workability of wire bonding can be improved. Because an area ratio of the main electrode and the control electrode of the semiconductor element can be designed without depending on the workability of the wire bonding, a small size and a large capacity of the semiconductor element can be realized. In addition, because the area of the main electrode 3 to be a high heat generating portion can be increased, heat easily diffuses and connection reliability with the connection wiring line can be improved. In addition, because the connection wiring line and the electrode are connected to each other through the conductive member 5 for the main electrode and the conductive member 6 for the control electrode, it is easy to alleviate thermal stress of a connecting portion or absorb an impact at the time of bonding and the connection reliability with the connection wiring line can be improved. As the conductive member 5 for the main electrode and the conductive member 6 for the control electrode, a material obtained by combining alloys consisting of copper or aluminum, low thermal expansion molybdenum, tungsten, and iron, and nickel in the form of a layer or powder can be used and the material may be used after a surface is plated with nickel, if necessary. A material having an intermediate thermal expansion coefficient of the semiconductor element 1 and the connection wiring lines 7 and 9 is preferably used from the viewpoint of improvement of the connection reliability. As the connection wiring lines 7 and 9, copper or aluminum and a material of a ribbon shape or a wire shape obtained by combining the copper and the aluminum can be used.

Meanwhile, when the connection wiring line 7 is connected, a lower area of the conductive member 6 for the control electrode connected to the control electrode 4 decreases and becomes unstable. Therefore, in this embodiment, the conductive member 6 for the control electrode is connected to the conductive member 5 for the main electrode by the insulating member 13, so that the conductive member 6 for the control electrode is prevented from being deformed or omitted at the time of connecting the connection wiring line 7. As the insulating member 13 to fix the conductive members 5 and 6, a material not removed or melt at the temperature at which the conductive members 5 and 6 are bonded to the electrodes 3 and 4 on the semiconductor element 1 by a resin such as an epoxy resin, a phenolic resin, and a polyimide resin can be used and an additive agent such as a silane coupling agent to secure adhesiveness with a filling material such as mica, clay, silica, boron nitride, and alumina or the conductive member may be mixed, if necessary.

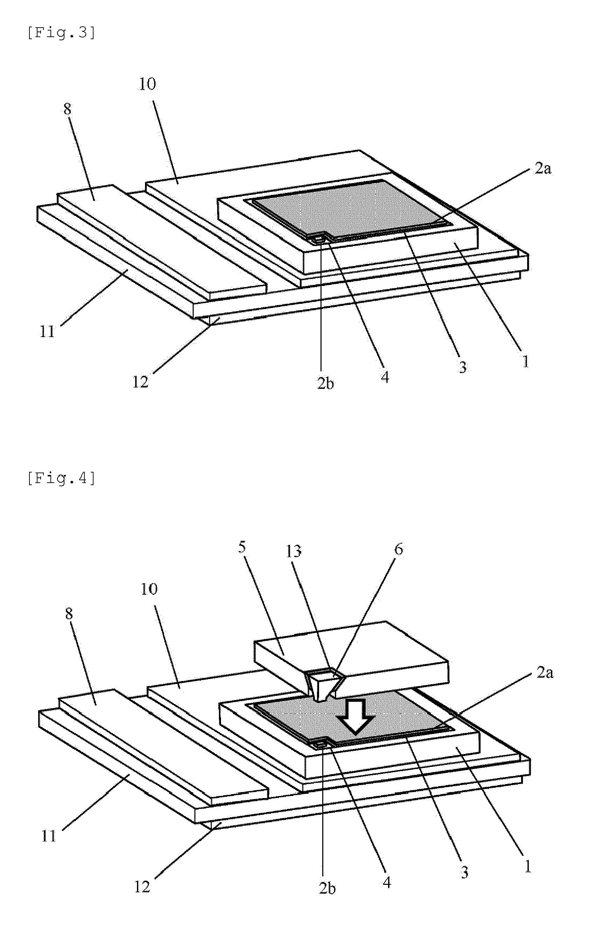

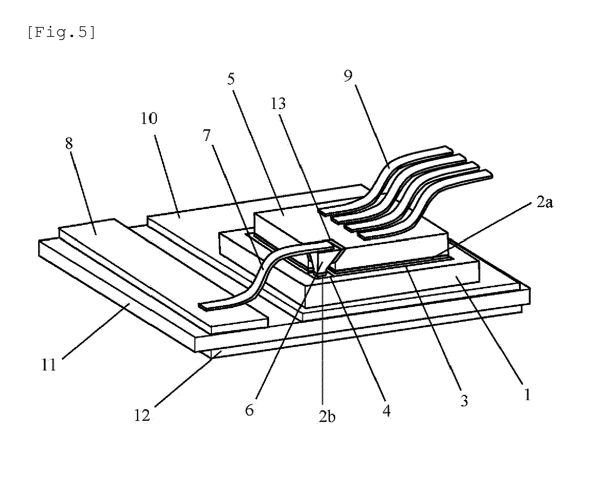

The semiconductor device according to this embodiment can be manufactured by the process illustrated in Fig. 2, for example. In Fig. 2, the semiconductor element 1 is connected to the upper portion of the wiring pattern of the insulating wiring substrate in which the wiring patterns 8 and 10 and the metal foil 12 are previously formed on both surfaces of the insulating substrate 11, using solder or particulate paste (not illustrated in the drawings). In Fig. 3, the bonding members 2a and 2b are applied to the upper portions of the main electrode 3 and the control electrode 4 on the semiconductor element 1 using a mask (not illustrated in the drawings) for printing. In Fig. 4, aresultant integrated by fixing the conductive member 5 for the main electrode and the conductive member 6 for the control electrode by the insulating member 13 is mounted on the bonding members 2a and 2b and the conductive members and the electrodes are bonded to each other by heat treatment. In Fig. 5, the conductive members and the terminals (not illustrated in the drawings) provided in the wiring pattern or the case (not illustrated in the drawings) on the insulating substrate 11 are connected by the connection wiring lines 7 and 9.

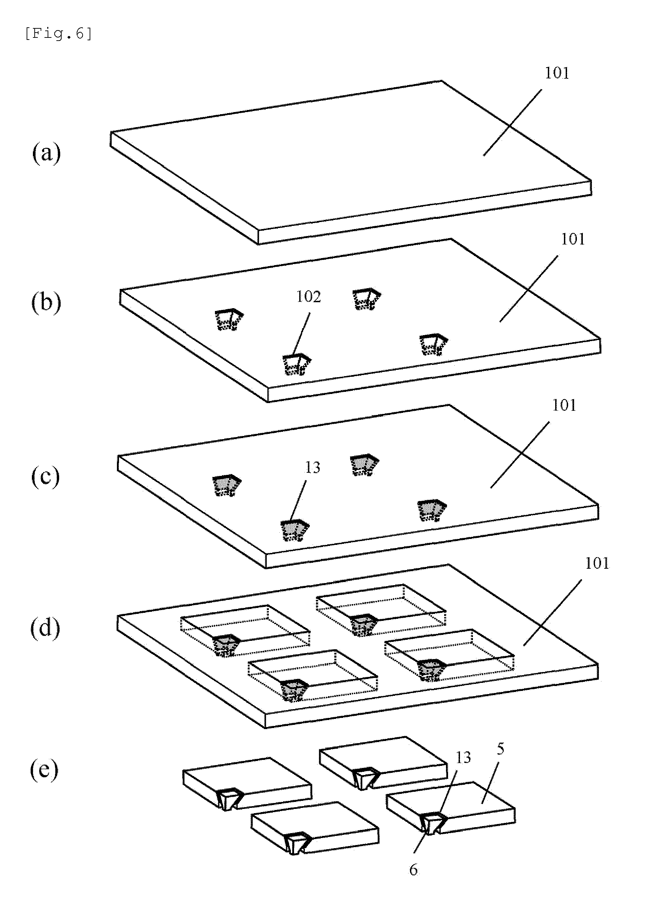

An example of manufacturing processes according to this embodiment for fixing the conductive member 5 for the main electrode and the conductive member 6 for the control electrode by the insulating member 13 and integrating the conductive member 5 for the main electrode and the conductive member 6 for the control electrode is illustrated in Figs. 6 (a) to 6(e). In Fig. 6(a), a flat material 101 becoming the conductive member is prepared. In Fig. 6(b), grooves 102 to separate a conductive member for a signal and a conductive member for power are formed using a processing means such as a press, etching, or a laser. In Fig. 6(c), the insulating member 13 is filled into the grooves formed by the previous process. Next, cutting is performed according to a shape of the conductive member illustrated in Fig. 6(d), so that the conductive member of a targeted shape illustrated in Fig. 6(e) is obtained. The manufacturing processes illustrated in Figs. 6(a) to 6(e) are exemplary and the conductive members may be manufactured by other manufacturing processes.

### [Second Embodiment]

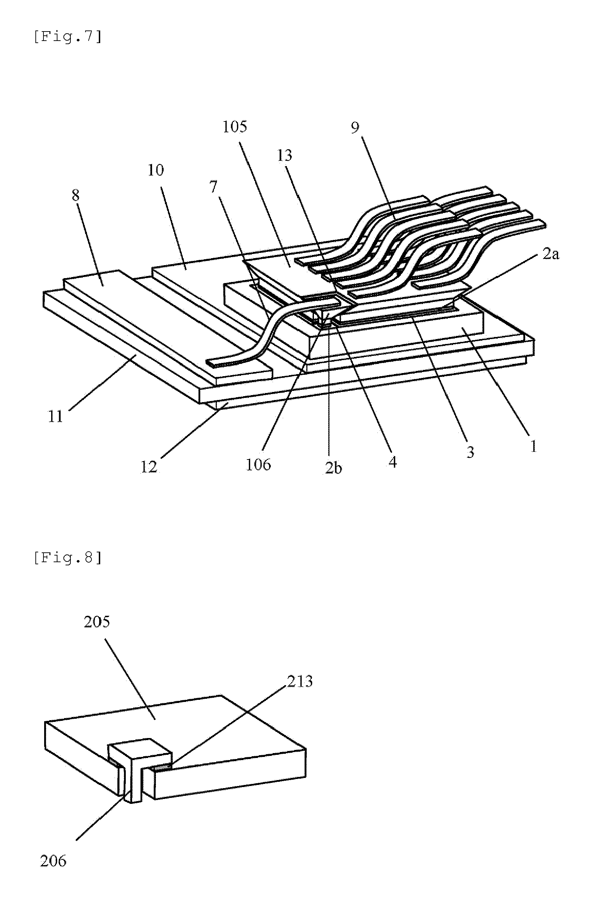

Fig. 7 is a perspective view illustrating a second embodiment of the present invention for a semiconductor device using another conductive member shape. In this embodiment, areas of connecting portions of a conductive member 105 for a main electrode and a conductive member 106 for a control electrode with connection wiring lines 7 and 9 are larger than areas of a main electrode 3 and a control electrode 4 provided in a semiconductor element 1. In the first embodiment, the area of the connecting portion of the control electrode 4 and the connection wiring line 7 can be increased by the conductive member 6 for the control electrode. However, because the area of the connection wiring line side is decreased in the conductive member 5 for the main electrode mounted on the main electrode 3, a sufficient connection wiring line number may not be secured. If the connection wiring line number of the main electrode is small, a current amount per wiring line increases and deterioration of the connecting portion with the conductive member easily occurs due to an increase in heat generation in the wiring line. Therefore, in this embodiment, the conductive member 105 for the main electrode mounted on the main electrode 3 is formed in a shape in which an area of a surface connected to the connection wiring line is larger than an area of a surface connected to the main electrode. As such, the area of the connection wiring line side of the conductive member 105 for the main electrode is increased, so that the connection wiring line number of the main electrode side can be increased in addition of the effect according to the first embodiment, and connection reliability of the main electrode and the connection wiring line can be improved.

### [Third Embodiment]

Fig. 8 is a perspective view illustrating a third embodiment of the present invention for another conductive member shape. A connection surface of a conductive member 206 for a control electrode with a connection wiring line and a connection surface of a conductive member 205 for a main electrode with a connection wiring line may not exist on the same plane. As illustrated in Fig. 8, the conductive member 206 for the control electrode and the conductive member 205 for the main electrode may be arranged such that the connection surface of the conductive member 206 for the control electrode with the connection wiring line is higher than the connection surface of the conductive member 205 for the main electrode with the connection wiring line and a part of the connection surface of the conductive member 206 for the control electrode covers the conductive member 205 for the main electrode through an insulating member 213. As such, a connecting portion of the connection surface of the conductive member 206 for the control electrode with the connection wiring line is connected to an upper portion of the conductive member 205 for the main electrode through the insulating member 213, so that the area of the connection surface of the conductive member 206 for the control electrode with the connection wiring line can be made to be larger than the area of the connection surface of the conductive member 206 for the control electrode with the control electrode. In this structure, stability at the time of bonding can be improved as compared with the first embodiment and connection workability is improved.

### [Fourth Embodiment]

A fourth embodiment of the present invention for another conductive member shape will be described. In the first to third embodiments, the structure in which the control electrode is arranged at the corner of the main electrode has been described as the example. However, the present invention can be applied to other electrode layout.

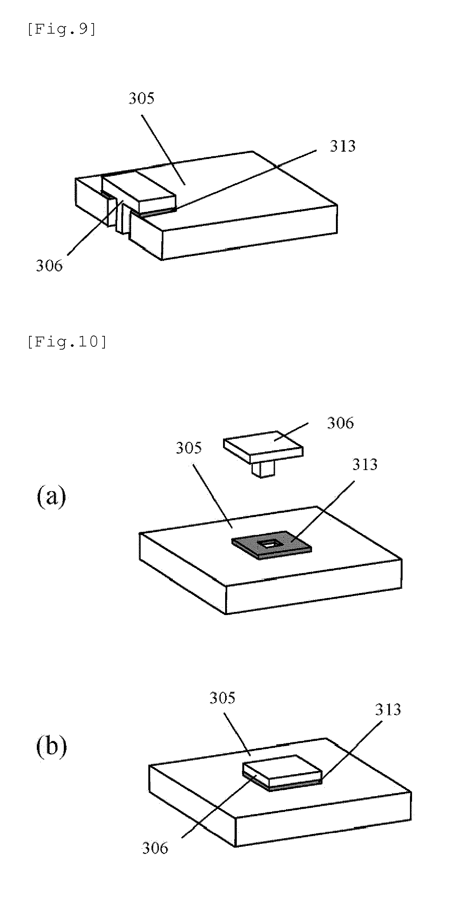

Fig. 9 is a perspective view illustrating a shape of a conductive member when one side of an outer circumferential portion of a main electrode is notched and a control electrode is arranged in the main electrode. Figs. 10(a) and 10(b) are perspective views illustrating a shape of a conductive member when the control electrode is arranged in a center portion of the main electrode. Fig. 10 (a) is an exploded perspective view of a conductive member and Fig. 10 (b) is a perspective view of a conductive member obtained by integrating a conductive member 305 for a main electrode and a conductive member 306 for a control electrode. InFigs. 9 to 10B, a basic structure of the conductive member is the same as that of Fig. 8 and the conductive member 305 for the main electrode and the conductive member 306 for the control electrode are arranged to correspond to the electrode layout, are fixed by an insulating member 313, and are integrated. As such, according to the present invention, connection reliability and connection workability with a connection wiring line can be improved without depending on the electrode layout.

The present invention has been described specifically using the embodiments. However, the present invention is not limited in a range described in the embodiments and various changes and modification can be made without departing from the gist of the present invention.
The above embodiments of the invention as well as the appended claims and figures show multiple characterizing features of the invention in specific combinations. The skilled person will easily be able to consider further combinations or sub-combinations of these features in order to adapt the invention as defined in the claims to his specific needs.

### Reference Signs List

1: semiconductor element
2a, 2b: bonding member
3: main electrode
4: control electrode
5, 105, 205, 305: conductive member for main electrode
6, 106, 206, 306: conductive member for control electrode
7, 9: connection wiring line
8, 10: wiring pattern
12: metal foil
13, 213, 313: insulating member

## Claims

1. A semiconductor device, **characterized in that**
a control electrode (4) and a main electrode (3) provided on a principal surface of a semiconductor element (1) are electrically connected to connection wiring lines (7) and (9) of wire or ribbon shapes through a conductive member,
the conductive member is divided into a conductive member (6) for a control electrode connected to the control electrode (4) and a conductive member (5) for a main electrode connected to the main electrode (3), the conductive member (6) for the control electrode and the conductive member (5) for the main electrode are fixed by an insulating member (13), and
an area of a surface of the conductive member (6) for the control electrode connected to the connection wiring line (7) is larger than an area of a surface of the conductive member (6) for the control electrode connected to the control electrode (4).

2. The semiconductor device according to claim 1, **characterized in that**
a thermal expansion coefficient of the conductive member (5) for the main electrode is larger than a thermal expansion coefficient of the semiconductor element (1) and is smaller than thermal expansion coefficients of the connection wiring lines (7) and (9).

3. The semiconductor device according to claim 1, **characterized in that**
thermal expansion coefficients of the conductive member (5) for the main electrode and the conductive member (6) for the control electrode are larger than a thermal expansion coefficient of the semiconductor element (1) and are smaller than thermal expansion coefficients of the connection wiring lines (7) and (9).

4. The semiconductor device according to claim 1, **characterized in that**
an area of a surface of the conductive member (5) for the main electrode connected to the connection wiring line (9) is larger than an area of a surface of the conductive member (5) for the main electrode connected to the main electrode (3).

5. The semiconductor device according to claim 1, **characterized in that**
a connecting portion of the conductive member (6) for the control electrode with the connection wiring line (7) is connected to an upper portion of the conductive member (5) for the main electrode through the insulating member (13).

6. The semiconductor device according to claim 1, **characterized in that**
the conductive member (6) for the control electrode is arranged such that a part thereof covers the conductive member (5) for the main electrode through the insulating member (13).
